# EUROPÄISCHE PATENTSCHRIFT

(11) **EP 3 509 764 B1**
(45) Veröffentlichungstag und Bekanntmachung des Hinweises auf die Patenterteilung: **07.06.2023**
(21) Anmeldenummer: 17762115.8
(22) Anmeldetag: 06.09.2017
(51) Int. Cl.: B06B 1/06, G06F 3/01, G10K 9/125

(54) **VORRICHTUNG ZUR ERZEUGUNG EINER HAPTISCHEN RÜCKMELDUNG UND ELEKTRONISCHES GERÄT**
APPARATUS FOR PRODUCING HAPTIC FEEDBACK AND ELECTRONIC DEVICE
DISPOSITIF DE GÉNÉRATION D'UN RETOUR HAPTIQUE ET APPAREIL ÉLECTRONIQUE

(30) Priorität: 07.09.2016 DE 102016116760
(43) Veröffentlichungstag der Anmeldung: 17.07.2019
(73) Patentinhaber: TDK Electronics AG, 81671 München (DE)
(72) Erfinder: RINNER, Franz, 8530 Deutschlandsberg (AT); MELISCHNIG, Alexander, 8010 Graz (AT)
(74) Vertreter: Epping - Hermann - Fischer
(86) Internationale Anmeldenummer: PCT/EP2017/072364
(87) Internationale Veröffentlichungsnummer: WO 2018/046546

(56) Entgegenhaltungen:
- EP-A1- 3 056 977
- WO-A1-2014/164018
- WO-A1-2016/067831
- US-A- 5 729 077
- US-A1- 2015 321 222

## Beschreibung

Die vorliegende Erfindung betrifft eine Vorrichtung zur Erzeugung einer haptischen Rückmeldung sowie ein elektronisches Gerät, das eine solche Vorrichtung aufweist. Bei diversen elektronischen Geräten, wie zum Beispiel bei berührungsempfindlichen Bildschirmen, ist eine künstlich erzeugte haptische Rückmeldung erwünscht, die einen natürlichen Tastendruck simuliert. Weitere Anwendungen, beispielsweise Spiele-Konsolen, bedienen sich ebenfalls Vibrationsmodulen, die eine haptische Rückmeldung erzeugen. In solchen Geräten ist oftmals der zur Verfügung stehende Platz sehr beschränkt, sodass die haptische Rückmeldung mit einer möglichst kleinen Vorrichtung erzeugt werden sollte.

Aus US 2014/0292144 A1 ist die Verwendung eines piezoelektrischen Aktuators als Antrieb für eine Vorrichtung zur Erzeugung einer haptischen Rückmeldung bekannt.

WO 2014/164018 A1 zeigt eine Vorrichtung zur Erzeugung eines taktilen Feedbacks, wobei die Vorrichtung ein piezoelektrisches Element aufweist, das parallel zu einer Membran angeordnet ist und an dem Rand der Membran sowie an dem Mittelpunkt der Membran befestigt ist.

US 5,729,077 A zeigt eine Vorrichtung, bei der ein piezoelektrisches Vielschichtelement zwischen zwei kegelstumpfförmigen metallischen Kappen angeordnet ist.

WO 2016/067831 A1 zeigt eine haptische Vorrichtung, bei der ein piezoelektrischer Film zwischen zwei Vibrationsplatten angeordnet ist, wobei jeweils die Endbereiche der Vibrationsplatten an dem piezoelektrischen Film befestigt sind.

EP 3056977 A1 zeigt eine Vorrichtung, bei der eine Membran derart an einen Befestigungsfilm befestigt ist, auf dessen Rückseite ein piezoelektrischer Film angeordnet ist, dass die Membran vorgespannt und gekrümmt ist.

US 2015/321222 A1 zeigt eine Vorrichtung, bei der ein piezoelektrisches Element auf eine Oberfläche einer Vibrationsplatte mit einem Klebefilm befestigt ist.

Aufgabe der vorliegenden Erfindung ist es, eine verbesserte Vorrichtung zur Erzeugung einer haptischen Rückmeldung anzugeben.

Diese Aufgabe wird durch eine Vorrichtung gemäß dem vorliegenden Anspruch 1 gelöst.

Es wird eine Vorrichtung zur Erzeugung einer haptischen Rückmeldung vorgeschlagen, die einen piezoelektrischen Aktuator und eine mechanische Struktur aufweist, wobei der piezoelektrische Aktuator dazu ausgestaltet ist, seine Ausdehnung in eine erste Richtung zu verändern, und wobei die mechanische Struktur dazu ausgestaltet ist, sich in Folge einer Änderung der Ausdehnung des piezoelektrischen Aktuators derart zu verformen, dass ein Bereich der mechanischen Struktur relativ zu dem piezoelektrischen Aktuator in eine zweite Richtung, die senkrecht zur ersten Richtung ist, bewegt wird.

Die mechanische Struktur ist ausgestaltet um eine Änderung der Ausdehnung des piezoelektrischen Aktuators in eine Bewegung des Bereichs in die zweite Richtung zu überführen. Der Bereich kann dabei der Bereich der mechanischen Struktur sein, der in Folge einer Änderung der Ausdehnung des piezoelektrischen Aktuators die größte Bewegung erfährt. Auch andere Bereiche der mechanischen Struktur können in Folge der Änderung der Ausdehnung des piezoelektrischen Aktuators verformt werden. Diese anderen Bereiche können dabei eine Bewegung erfahren, deren Bewegungsamplitude kleiner ist als die Bewegung des Bereiches.

Durch die Bewegung des Bereiches wird die haptische Rückmeldung erzeugt.

Dazu können beispielsweise Gewichte oder Gehäuseelemente, wie etwa ein Deckel oder eine Bodenplatte, an dem Bereich befestigt sein. Diese Gewichte oder Gehäuseelemente können einer Bewegung des Bereiches folgen. Durch die Bewegung des Bereichs kann eine Vibration erzeugt werden, die ein Nutzer als haptische Rückmeldung wahrnimmt.

Die mechanische Struktur ermöglicht somit, die Bewegung des piezoelektrischen Aktuators in eine zur Ausdehnung des piezoelektrischen Aktuators senkrechten zweiten Richtung zu übersetzen. Die Vorrichtung kann in die zweite Richtung eine geringere Ausdehnung als in die erste Richtung aufweisen. Dementsprechend kann die haptische Rückmeldung oder die Vibration in eine Richtung wirken, in die die Vorrichtung sehr flach ist. Eine solche flache Form der Vorrichtung kann für den Einbau in ein elektronisches Gerät vorteilhaft sein.

Der piezoelektrische Aktuator kann ein Vielschichtbauelement sein, bei dem Innenelektroden und piezoelektrische Schichten in einer Stapelrichtung abwechselnd übereinandergestapelt sind. Die Stapelrichtung kann parallel zu einer ersten Richtung sein. Der piezoelektrische Aktuator kann dazu ausgestaltet, in Folge einer an die Innenelektroden angelegten elektrischen Spannung seine Ausdehnung in die erste Richtung zu ändern. Der piezoelektrische Aktuator kann sich ausdehnen oder zusammenziehen. Bei einer Ausdehnung vergrößert sich die Länge des Aktuators in die erste Richtung. Bei einem Zusammenziehen verringert sich die Länge des Aktuators in die erste Richtung. Der Aktuator kann dazu ausgestaltet sein, dass er seine Ausdehnung in Folge einer an die Innenelektroden angelegten Wechselspannung ständig ändert, wodurch eine Vibration erzeugt wird.

Die mechanische Struktur kann Stahl oder Bronze aufweisen. Insbesondere kann die mechanische Struktur aus Stahl oder Bronze gefertigt sein. Die mechanische Struktur kann einstückig sein.

Die mechanische Struktur kann dazu ausgestaltet sein, dass der Bereich der mechanischen Struktur in Folge einer Änderung der Ausdehnung des piezoelektrischen Aktuators in die zweite Richtung um eine Strecke bewegt wird, die mindestens 10-mal so groß ist wie die Änderung der Ausdehnung des piezoelektrischen Aktuators in die erste Richtung. Vorzugsweise ist die Strecke mindestens 20-mal so groß wie die Änderung der Ausdehnung des piezoelektrischen Aktuators. Dementsprechend kann die mechanische Struktur eine Hubübersetzung für die Änderung der Ausdehnung des piezoelektrischen Aktuators von mindestens 1:10, vorzugsweise von mindestens 1:20, ermöglichen. Die mechanische Struktur kann dementsprechend für eine Vergrößerung der Bewegungsamplitude sorgen. Dementsprechend kann die mechanische Struktur die erzeugten Vibrationen beziehungsweise das erzeugte haptische Feedback, welches von dem piezoelektrischen Aktuator erzeugbar ist, erheblich verstärken.

Die mechanische Struktur weist eine Teilstruktur auf, die dazu ausgestaltet ist, sich in Folge einer Änderung der Ausdehnung des piezoelektrischen Aktuators nicht relativ zu dem piezoelektrischen Aktuator in die zweite Richtung zu bewegen. Die haptische Rückmeldung wird durch eine Relativbewegung des Bereichs zu der Teilstruktur erzeugt. Die Teilstruktur kann dabei als Gegenhalter zu dem piezoelektrischen Aktuator wirken. Insbesondere kann ein Hebelarm, der den Bereich aufweist, derart mit dem piezoelektrischen Aktuator und der Teilstruktur verbunden sein, dass eine Ausdehnung des piezoelektrischen Aktuators zu einer Drehung des Hebelarms um einen Drehpunkt führt, der durch eine Verbindungsstelle der Teilstruktur und des Hebelarms gebildet wird.

Die Teilstruktur erstreckt sich in der ersten Richtung balkenförmig, wobei die Teilstruktur parallel zu dem piezoelektrischen Aktuator angeordnet ist.

Die mechanische Struktur kann einen ersten Hebelarm aufweisen, der den Bereich aufweist, wobei ein erstes Ende des piezoelektrischen Aktuators an dem ersten Hebelarm fixiert ist. Dementsprechend kann bei einer Änderung der Ausdehnung des piezoelektrischen Aktuators die Position des Hebelarms, an dem der Aktuator befestigt ist, in die erste Richtung bewegt werden. Der piezoelektrische Aktuator kann beispielsweise durch ein Verklemmen, ein Verkleben oder Löten mit dem ersten Hebelarm verbunden sein.

Der erste Hebelarm kann beweglich mit der Teilstruktur verbunden sein. Der erste Hebelarm und die Teilstruktur können einstückig sein und über eine Dünnstelle biegsam miteinander verbunden sein. Alternativ können der erste Hebelarm und die Teilstruktur mehrstückig sein und über ein Gelenk beweglich miteinander verbunden sein. Dadurch, dass der erste Hebelarm relativ zu der Teilstruktur beweglich ist, ist die mechanische Struktur insgesamt in sich beweglich und kann auf diese Weise verformt werden. Der erste Hebelarm und die Teilstruktur können so ausgestaltet sein, dass die Bewegungen beziehungsweise Verformungen stets elastisch verlaufen.

Der erste Hebelarm kann einen ersten Endabschnitt, einen zweiten Endabschnitt und einen mittleren Abschnitt aufweisen. Die Endabschnitte können zueinander parallel sein. Der mittlere Abschnitt kann die beiden Endabschnitte miteinander verbinden und zu den beiden Endabschnitten senkrecht sein. Dementsprechend kann der erste Hebelarm U-förmig sein. Der mittlere Abschnitt kann länger sein als der erste Endabschnitt und als der zweite Endabschnitt. Der mittlere Abschnitt kann dabei parallel zu dem piezoelektrischen Aktuator angeordnet sein. Der piezoelektrische Aktuator kann zwischen den beiden Endabschnitten angeordnet sein.

Der Bereich, der dazu ausgestaltet ist, bei einer Verformung der mechanischen Struktur in die zweite Richtung bewegt zu werden, kann in dem mittleren Abschnitt angeordnet sein. Insbesondere kann der mittlere Abschnitt bei einer Verformung des ersten Hebelarms der Abschnitt sein, der die größte Änderung seiner Position erfährt. Beispielsweise kann der Hebelarm derart ausgestaltet sein, dass die beiden Endabschnitte in Folge einer Änderung der Ausdehnung des piezoelektrischen Aktuators entweder auseinandergedrückt werden oder zusammengezogen werden, wodurch der mittlere Abschnitt gewölbt wird.

Der erste Endabschnitt kann beweglich an der Teilstruktur befestigt sein und ein Ende des piezoelektrischen Aktuators kann an dem ersten Endabschnitt fixiert sein.

Der zweite Endabschnitt kann eine Dünnstelle aufweisen, die den zweiten Endabschnitt in einen ersten Teilabschnitt und einen zweiten Teilabschnitt unterteilt, die zueinander biegsam sind, wobei der erste Teilabschnitt sich an den mittleren Abschnitt anschließt und wobei der zweite Teilabschnitt dazu ausgestaltet ist, an einer Befestigungsvorrichtung fixiert zu werden. Die Befestigungsvorrichtung ist nicht Teil der Vorrichtung zur Erzeugung der haptischen Rückmeldung. Die Befestigungsvorrichtung kann Teil eines elektronischen Gerätes sein, welches die Vorrichtung zur Erzeugung der haptischen Rückmeldung aufweist.

Die mechanische Struktur kann einen zweiten Hebelarm aufweisen, der einen Bereich aufweist, der dazu ausgestaltet ist, sich bei einer Verformung der mechanischen Struktur in Folge einer Änderung der Ausdehnung des piezoelektrischen Aktuators in die zweite Richtung zu bewegen. Ein zweites Ende des piezoelektrischen Aktuators kann an dem zweiten Hebelarm fixiert sein. Die Hebelarme können derart ausgestaltet sein, dass der Bereich des ersten Hebelarms und der Bereich des zweiten Hebelarms stets in die gleiche Richtung bewegt werden. Jeder der Hebelarme kann einen ersten Endabschnitt und einen zweiten Endabschnitt aufweisen, die jeweils eine Dünnstelle aufweisen, wobei die Dünnstellen in einer Ebene liegen. Dadurch kann sichergestellt werden, dass es vermieden wird, dass die mechanische Struktur verklemmt wird oder mechanisch blockiert.

Der zweite Hebelarm kann derart ausgestaltet sein, dass seine beiden Endabschnitte in Folge einer Änderung der Ausdehnung des piezoelektrischen Aktuators entweder auseinandergedrückt werden oder zusammengezogen werden, wodurch der mittlere Abschnitt gewölbt wird.

Die mechanische Struktur kann mehrteilig sein. Die Vorrichtung kann eine Haltevorrichtung aufweisen, die dazu ausgestaltet ist, auf die mechanische Struktur von außen eine Kraft auszuüben, durch die die mechanische Struktur zusammengehalten wird.

Der piezoelektrischen Aktuator kann einen Vielschichtaufbau aufweisen, bei dem in einer Stapelrichtung Innenelektroden und piezoelektrische Schichten abwechselnd übereinander angeordnet sind, wobei die erste Richtung parallel zu der Stapelrichtung ist.

Ferner betrifft die vorliegende Erfindung ein elektronisches Gerät, das die oben beschriebene Vorrichtung sowie ein erstes Gehäuseelement und ein zweites Gehäuseelement aufweist. Das erste und das zweite Gehäuseelement sind derart mit der mechanischen Struktur befestigt, dass bei einer Änderung der Ausdehnung des piezoelektrischen Aktuators in die erste Richtung die Gehäuseelemente relativ zueinander bewegt werden. Beispielsweise kann das erste Gehäuseelement an der Teilstruktur befestigt sein, die nicht in die zweite Richtung relativ zu dem piezoelektrischen Aktuator bewegt wird, und das zweite Gehäuseteil kann an dem Bereich der mechanischen Struktur befestigt sein, der in Folge einer Änderung der Ausdehnung des piezoelektrischen Aktuators in die zweite Richtung bewegt wird.

Bei dem elektronischen Gerät kann es sich beispielsweise um einen Bildschirm, insbesondere einen berührungssensitiven Bildschirm, handeln. Bei dem elektronischen Gerät kann es sich um ein Steuergerät einer Spielekonsole handeln.

Im Folgenden wird die Erfindung anhand von Figuren näher erläutert.

Die Figuren 1 und 2 zeigen eine Vorrichtung zur Erzeugung einer haptischen Rückmeldung.

Die Figuren 3 und 4 zeigen eine mechanische Struktur.

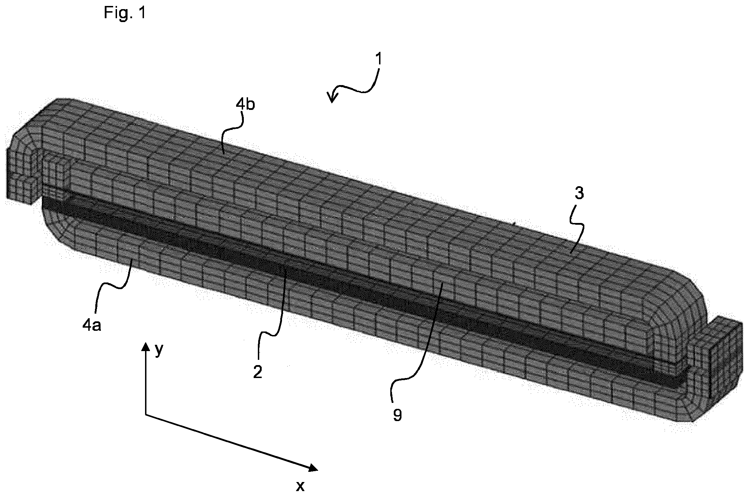

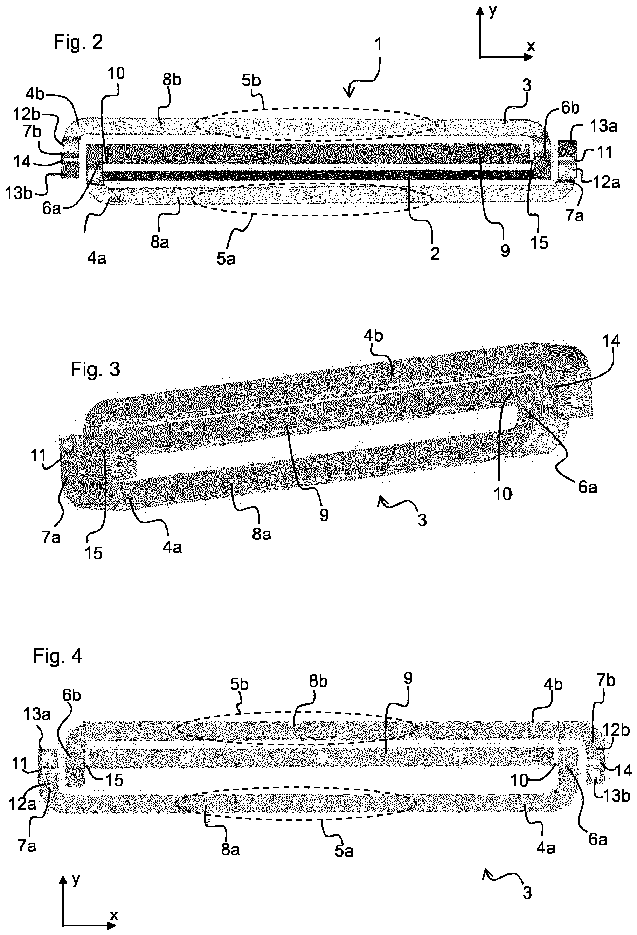

Die Figuren 1 und 2 zeigen eine Vorrichtung 1 zur Erzeugung einer haptischen Rückmeldung. Figur 1 zeigt die Vorrichtung 1 in einer perspektivischen Ansicht. Figur 2 zeigt die Vorrichtung 1 in einem Querschnitt.

Die Vorrichtung 1 weist einen piezoelektrischen Aktuator 2 und eine mechanische Struktur 3 auf, die dazu ausgestaltet ist, eine Längenänderung des piezoelektrischen Aktuators 2 in eine mechanische Bewegung mit einem vergrößerten Bewegungsumfang zu übersetzen. Der piezoelektrische Aktuator 2 ist ein Vielschichtbauelement, das dazu ausgestaltet ist in eine Stapelrichtung, in der Innenelektroden und piezoelektrische Schichten abwechselnd übereinandergestapelt sind, zu schwingen. Die Stapelrichtung ist parallel zu einer ersten Richtung x. Der piezoelektrische Aktuator 2 ist dazu ausgestaltet, in Folge einer an die Innenelektroden angelegten elektrischen Spannung seine Ausdehnung in die erste Richtung x zu ändern, wobei der piezoelektrische Aktuator 2 sich abwechselnd ausdehnt und zusammenzieht.

Figur 3 zeigt die mechanische Struktur 3 in einer perspektivischen Ansicht. Figur 4 zeigt die mechanische Struktur 3 in einem Querschnitt.

Die mechanische Struktur 3 weist einen ersten Hebelarm 4a und einen zweiten Hebelarm 4b auf. Die mechanische Struktur 3 ist derart ausgestaltet, dass sich in Folge einer Änderung der Ausdehnung des piezoelektrischen Aktuators 2 die mechanische Struktur 3 derart verformt, dass ein Bereich 5a des ersten Hebelarms 4a und ein Bereich 5b des zweiten Hebelarms 4b jeweils in eine zweite Richtung y bewegt werden. Die zweite Richtung y ist senkrecht zu der ersten Richtung x. Die mechanische Struktur 3 ist insbesondere derart geformt, dass die Bereiche 5a, 5b des ersten und des zweiten Hebelarms 4a, 4b sich um eine Strecke bewegen, die größer ist als die Längenänderung des piezoelektrischen Aktuators 2 in die erste Richtung x. Beispielsweise kann die Strecke um die die Bereiche 4a, 4b des ersten und des zweiten Hebelarms 5a, 5b bewegt werden mindestens 10-mal so groß sein wie die Änderung der Ausdehnung des piezoelektrischen Aktuators 2. Dementsprechend kann die mechanische Struktur 3 eine Hubübersetzung von 1:10 ermöglichen.

Im Folgenden wird zunächst der erste Hebelarm 4a genauer betrachtet. Der erste Hebelarm 4a ist U-förmig. Der erste Hebelarm 4a weist einen ersten Endabschnitt 6a und einen zweiten Endabschnitt 7a auf, die parallel zueinander angeordnet sind. Ferner weist der erste Hebelarm 4a einen mittleren Abschnitt 8a auf, der senkrecht zu dem ersten und dem zweiten Endabschnitt 6a, 7a ist und der die beiden Endabschnitte 6a, 7a miteinander verbindet. Der Bereich 5a, der in Folge einer Änderung der Ausdehnung des piezoelektrischen Aktuators 2 die größte Bewegung in die zweite Richtung y erfährt, ist in dem mittleren Abschnitt 8a des ersten Hebelarms 4a angeordnet.

Die mechanische Struktur 3 weist ferner eine Teilstruktur 9 auf, die dazu ausgestaltet ist, sich in Folge einer Änderung der Ausdehnung des piezoelektrischen Aktuators 2 nicht zu bewegen. Diese Teilstruktur 9 dient als Gegenhalter zu dem piezoelektrischen Aktuator 2. Sie bildet einen Fixpunkt, zu dem sich der piezoelektrische Aktuator 2 und die Hebelarme 4a, 4b relativ bewegen können. Die Teilstruktur 9 ist balkenförmig. Die Teilstruktur 9 ist parallel zu dem piezoelektrischen Aktuator 2 angeordnet. Die Teilstruktur 9 verläuft in einem Abstand von weniger als 1 mm parallel zu dem piezoelektrischen Aktuator 2.

Die Teilstruktur 9 und der erste Hebelarm 4a sind einstückig geformt. Die Teilstruktur 9 und der erste Hebelarm 4a sind über eine erste Dünnstelle 10 miteinander verbunden. Der erste Hebelarm 4a kann relativ zu der Teilstruktur 9 bewegt werden, indem die Dünnstelle 10 gebogen wird. Die erste Dünnstelle 10 ist dazu ausgestaltet, sich bei einer Biegung elastisch zu verformen. Die erste Dünnstelle 10 stellt einen Drehpunkt dar, um den der erste Hebelarm 4a relativ zu der Teilstruktur 9 gedreht werden kann. Der erste Hebelarm 4a ist somit beweglich an der Teilstruktur 9 fixiert. Ferner ist der piezoelektrische Aktuator 2 an dem ersten Hebelarm 4a befestigt. Der piezoelektrische Aktuator 2 kann nicht lösbar an dem ersten Hebelarm 4a befestigt sein, beispielsweise durch Klemmen, Kleben, Löten oder andere Befestigungsmethoden.

Die Teilstruktur 9 und der piezoelektrische Aktuator 2 sind jeweils mit dem ersten Endabschnitt 6a des ersten Hebelarms 4a verbunden. Die Teilstruktur 9 ist dabei beweglich mit dem ersten Endabschnitt 6a verbunden. Der piezoelektrische Aktuator 2 ist an dem ersten Endabschnitt 4a derart fixiert, dass durch eine Ausdehnung oder ein Zusammenziehen des piezoelektrischen Aktuators 2 der erste Endabschnitt 4a bewegt wird. Der piezoelektrische Aktuator 2 ist an einer Position des ersten Endabschnittes 4a befestigt, die näher an dem mittleren Abschnitt 8a ist als die Position des ersten Endabschnittes 4a, an der die Teilstruktur 9 befestigt ist.

Der erste Hebelarm 4a weist ferner den zweiten Endabschnitt 7a auf. Der zweite Endabschnitt 7a ist durch eine zweite Dünnstelle 11 in zwei Teilabschnitte 12a, 13a unterteilt. Ein erster Teilabschnitt 12a des zweiten Endabschnittes 7a schließt sich unmittelbar an den mittleren Abschnitt 8a an. Ein zweiter Teilabschnitt 13a des zweiten Endabschnittes 7a ist an der von dem mittleren Abschnitt 8a wegweisenden Seite des zweiten Endabschnittes 7a angeordnet. Die zweite Dünnstelle 11 ermöglicht es, dass die beiden Teilabschnitte 12a, 13a des zweiten Endabschnittes 7a relativ zueinander bewegt werden können. Insbesondere kann der zweite Endabschnitt 7a an der zweiten Dünnstelle 11 gebogen werden. Der zweite Teilabschnitt 13a ist dazu ausgestaltet, an einer externen Befestigungsvorrichtung fixiert zu werden.

Es wird nunmehr der Fall betrachtet, dass der piezoelektrische Aktuator 2 sich in Folge einer angelegten Spannung in die erste Richtung x ausdehnt. In diesem Fall wird die erste Dünnstelle 10 zwischen der Teilstruktur 9 und dem ersten Endabschnitt 6a des ersten Hebelarms 4a gebogen. Der piezoelektrische Aktuator 2 drückt den ersten Endabschnitt 6a in die erste Richtung x. Dadurch wird der erste Endabschnitt 6a um die erste Dünnstelle 10 als Drehpunkt gebogen. Ist der zweite Teilbereich 13a des zweiten Endabschnittes 7a an der Befestigungsvorrichtung fixiert, kann er dementsprechend der Drehung nicht folgen. Um die Drehbewegung des ersten Endabschnittes 6a auszugleichen, wird daher der zweite Endabschnitt 7a an seiner Dünnstelle 11 gebogen. Dabei bewegt sich der erste Teilabschnitt 12a des zweiten Endabschnittes 7a relativ zu dem zweiten Teilabschnitt 13a des zweiten Endabschnittes 7a. Damit einhergehend ist eine Wölbung des mittleren Abschnittes 8a. Insbesondere wird der mittlere Abschnitt 8a in die zweite Richtung y bewegt. Bei der Darstellung in den Figuren 1 und 2 wird der mittlere Abschnitt 8a nach unten gebogen werden. Eine besonders große Bewegung erfährt dabei der gekennzeichnete Bereich 5a.

Die mechanische Struktur 3 weist ferner den zweiten Hebelarm 4b auf. Der zweite Hebelarm 4b weist einen identischen Aufbau zu dem ersten Hebelarm 4a auf. Auch der zweite Hebelarm 4b weist einen ersten Endabschnitt 6b, der beweglich mit der Teilstruktur 9 verbunden ist und der an dem piezoelektrischen Aktuator 2 fixiert ist, einen mittleren Bereich 8b und einen zweiten Endabschnitt 7b auf, der durch eine dritte Dünnstelle 14 in zwei Teilabschnitte 12b, 13b unterteilt wird. Die Teilstruktur 9 und der piezoelektrische Aktuator 2 sind derart mit dem zweiten Hebelarm 4b verbunden, dass sich der Bereich 5b des zweiten Hebelarms 4b, der in Folge einer Änderung der Ausdehnung des piezoelektrischen Aktuators 2 eine maximale Positionsänderung erfährt, stets in die gleiche Richtung bewegt wie der Bereich 5a des ersten Hebelarms 4a. Dazu ist der piezoelektrische Aktuator 2 an dem zweiten Hebelarm 4b an einer Position des ersten Endabschnittes 6b fixiert, die weiter von dem mittleren Abschnitt 8b weg ist als die Position, an der die Teilstruktur 9 mit dem zweiten Hebelarm 4b verbunden ist. Dadurch wird sichergestellt, dass der erste Endabschnitt 6b des zweiten Hebelarms 4b in die gleiche Drehrichtung gedreht wird wie der erste Endabschnitt 6a des ersten Hebelarms 4a. Der erste Endabschnitt 6b des zweiten Hebelarms 4b ist über eine vierte Dünnstelle 15 mit der Teilstruktur 9 verbunden.

Bei dem in den Figuren 1 und 2 gezeigten Ausführungsbeispiel bewegen sich die Bereiche 5a, 5b der mittleren Abschnitte 8a, 8b des ersten und des zweiten Hebelarms 4a, 4b, wie oben diskutiert, in Folge einer Ausdehnung des piezoelektrischen Aktuators 2 nach unten. In Folge eines Zusammenziehens des piezoelektrischen Aktautors 2 bewegen sich die Bereiche 5a, 5b nach oben.

In einem alternativen Ausführungsbeispiel kann die mechanische Struktur 3 mehrteilig sein. In diesem Fall können eine oder mehrere der Dünnstellen 10, 11, 14, 15 durch Gelenke ersetzt werden, an denen eine Relativbewegung des ersten Endabschnittes 6a, 6b des jeweiligen Hebelarms 4a, 4b relativ zu der Teilstruktur 9 beziehungsweise eine Bewegung des ersten Teilabschnitts 12a, 12b relativ zu dem zweiten Teilabschnitt 13a, 13b der zweiten Endabschnitte 7a, 7b ermöglicht wird. In diesem Fall kann die Vorrichtung 1 ferner Elemente aufweisen, die dazu ausgestaltet sind, von außen eine Kraft auf die mechanische Struktur 3 auszuüben, um diese zusammenzuhalten. Dabei kann es sich beispielsweise um Federn handeln.

Die vier Dünnstellen 10, 11, 14, 15, die als Drehpunkte fungieren, sind in einer Ebene angeordnet. Dadurch kann sichergestellt werden, dass eine Verklemmung der mechanischen Struktur 3 verhindert wird und der Abstand zwischen den äußeren Befestigungsvorrichtungen konstant gehalten werden kann. Die vier Dünnstellen 10, 11, 14, 15 werden auch dann als in einer Ebene liegend angesehen, sofern sie um maximal 1 mm von der Ebene entfernt angeordnet sind. Eine Anordnung einer der Dünnstellen 10, 11, 14, 15 versetzt um weniger als 1 mm aus der Ebene heraus, führt nicht zu einer Verklemmung der mechanischen Struktur 3.

Die haptische Rückmeldung wird nunmehr durch eine Relativbewegung zwischen der Teilstruktur 9 und den Hebelarmen 4a, 4b erzeugt. Gehäuseelemente eines elektronischen Gerätes können beispielsweise an der Teilstruktur 9 und den Hebelarmen 4a, 4b befestigt werden. Bei den Gehäuseelementen kann es sich beispielsweise um eine Bodenplatte, einen Deckel oder Gewichte handeln. Diese können an der Teilstruktur 9 und den Hebelarmen 4a, 4b durch Schraubverbindungen oder andere Verbindungen fixiert werden. Wird nun ein an der Teilstruktur 9 befestigtes Gehäuseelement relativ zu einem an einem der Hebelarme 4a, 4b befestigten Gehäuseelement oder Gewicht bewegt, entsteht dadurch die haptische Rückmeldung, die ein Nutzer des elektronischen Gerätes wahrnimmt.

### Bezugszeichenliste

- 1: Vorrichtung
- 2: Aktuator
- 3: mechanische Struktur
- 4a: erster Hebelarm
- 4b: zweiter Hebelarm
- 5a: Bereich des ersten Hebelarms
- 5b: Bereich des zweiten Hebelarms
- 6a: erster Endabschnitt des ersten Hebelarms
- 6b: erster Endabschnitt des zweiten Hebelarms
- 7a: zweiter Endabschnitt des ersten Hebelarms
- 7b: zweiter Endabschnitt des zweiten Hebelarms
- 8a: mittlerer Abschnitt des ersten Hebelarms
- 8b: mittlerer Abschnitt des zweiten Hebelarms
- 9: Teilstruktur
- 10: erste Dünnstelle
- 11: zweite Dünnstelle
- 12a: erster Teilabschnitt des zweiten Endabschnitts des ersten Hebelarms
- 12b: erster Teilabschnitt des zweiten Endabschnitts des zweiten Hebelarms
- 13a: zweiter Teilabschnitt des zweiten Endabschnitts des ersten Hebelarms
- 13b: zweiter Teilabschnitt des zweiten Endabschnitts des zweiten Hebelarms
- 14: dritte Dünnstelle
- 15: vierte Dünnstelle

- x: erste Richtung
- y: zweite Richtung

## Patentansprüche

1. Vorrichtung (1) zur Erzeugung einer haptischen Rückmeldung,
aufweisend einen piezoelektrischen Aktuator (2) und eine mechanische Struktur (3),
wobei der piezoelektrische Aktuator (2) dazu ausgestaltet ist, seine Ausdehnung in eine erste Richtung (x) zu verändern, und
wobei die mechanische Struktur (3) dazu ausgestaltet ist, sich in Folge einer Änderung der Ausdehnung des piezoelektrischen Aktuators (2) derart zu verformen, dass ein Bereich (5a, 5b) der mechanischen Struktur (3) relativ zu dem piezoelektrischen Aktuator (2) in eine zweite Richtung (y), die senkrecht zur ersten Richtung (x) ist, bewegt wird,
**dadurch gekennzeichnet,**
**dass** die mechanische Struktur (3) eine Teilstruktur (9) aufweist, die dazu ausgestaltet ist, sich in Folge einer Änderung der Ausdehnung des piezoelektrischen Aktuators (2) nicht relativ zu dem piezoelektrischen Aktuator (2) in die zweite Richtung zu bewegen,
wobei die haptische Rückmeldung durch eine Relativbewegung des Bereichs (5a, 5b) zu der Teilstruktur (9) erzeugt wird,
wobei die Teilstruktur (9) sich in der ersten Richtung (x) balkenförmig erstreckt und wobei die Teilstruktur (9) parallel zu dem piezoelektrischen Aktuator (2) angeordnet ist.

2. Vorrichtung (1) gemäß dem vorherigen Anspruch,
wobei die mechanische Struktur (3) dazu ausgestaltet ist, dass in Folge einer Änderung der Ausdehnung des piezoelektrischen Aktuators (2) der Bereich (5a, 5b) der mechanischen Struktur (3) um eine Strecke in die zweite Richtung (y) bewegt wird, die mindestens zehnmal so groß ist wie die Änderung der Ausdehnung des piezoelektrischen Aktuators (2) in die erste Richtung (x) .

3. Vorrichtung (1) gemäß dem vorherigen Anspruch,
wobei die Teilstruktur (9) in einem Abstand von weniger als 1 mm parallel zu dem piezoelektrischen Aktuator (2) verläuft.

4. Vorrichtung (1) gemäß einem der vorherigen Ansprüche,
wobei die mechanische Struktur (3) einen ersten Hebelarm (4a) aufweist, der den Bereich (5a) aufweist, und
wobei ein erstes Ende des piezoelektrischen Aktuators (2) an dem ersten Hebelarm (4a) fixiert ist.

5. Vorrichtung (1) gemäß der Anspruch 4,
wobei der erste Hebelarm (4a) beweglich mit der Teilstruktur (9) verbunden ist.

6. Vorrichtung (1) gemäß dem vorherigen Anspruch,
wobei der erste Hebelarm (4a) und die Teilstruktur (9) einstückig sind und über eine Dünnstelle (10) biegsam miteinander verbunden sind,
oder
wobei der erste Hebelarm (4a) und die Teilstruktur (9) mehrstückig sind und über ein Gelenk beweglich miteinander verbunden sind.

7. Vorrichtung (1) gemäß einem der Ansprüche 4 bis 6,
wobei der erste Hebelarm (4a) einen ersten Endabschnitt (6a), einen zweiten Endabschnitt (7a) und einen mittleren Abschnitt (8a) aufweist, wobei die Endabschnitte (6a, 7a) zueinander parallel sind und wobei der mittlere Abschnitt (8a) die beiden Endabschnitte (6a, 7a) miteinander verbindet und zu den beiden Endabschnitten (6a, 7a) senkrecht ist, und wobei der Bereich (5a), der dazu ausgestaltet ist, bei einer Verformung der mechanischen Struktur (3) in die zweite Richtung (y) bewegt zu werden, in dem mittleren Abschnitt (8a) angeordnet ist.

8. Vorrichtung (1) gemäß dem vorherigen Anspruch,
wobei der erste Hebelarm (4a) derart ausgestaltet ist, dass die beiden Endabschnitte (6a, 7a) in Folge einer Änderung der Ausdehnung des piezoelektrischen Aktuators (2) entweder auseinandergedrückt werden oder zusammengezogen werden, wodurch der mittlere Abschnitt (8a) gewölbt wird.

9. Vorrichtung (1) gemäß einem der Ansprüche 7 oder 8, wobei der erste Endabschnitt (6a) beweglich an der Teilstruktur (9) befestigt ist, und
wobei ein Ende des piezoelektrischen Aktuators (2) an dem ersten Endabschnitt (6a) fixiert ist.

10. Vorrichtung (1) gemäß einem der Ansprüche 7 bis 9,
wobei der zweite Endabschnitt (7a) eine Dünnstelle (11) aufweist, die den zweiten Endabschnitt (7a) in einen ersten Teilabschnitt (12a) und einen zweiten Teilabschnitt (12b) unterteilt, die zueinander biegsam sind,
wobei der erste Teilabschnitt (12a) sich an den mittleren Abschnitt (8a) anschließt, und
wobei der zweite Teilabschnitt (12b) dazu ausgestaltet ist, an einer Befestigungsvorrichtung fixiert zu werden.

11. Vorrichtung (1) gemäß einem der Ansprüche 4 bis 10,
wobei die mechanische Struktur (3) einen zweiten Hebelarm (4b) aufweist, der einen Bereich (5b) aufweist, der dazu ausgestaltet ist, sich bei einer Verformung der mechanischen Struktur (3) in Folge eine Änderung der Ausdehnung des piezoelektrischen Aktuators (2) in die zweite Richtung (y) zu bewegen,
wobei ein zweites Ende des piezoelektrischen Aktuators (2) an dem zweiten Hebelarm (4b) fixiert ist, und
wobei die Hebelarme (4a, 4b) derart ausgestaltet sind, dass der Bereich (5a) des ersten Hebelarms (4a) und der Bereich (5b) des zweiten Hebelarms (4b) stets in die gleiche Richtung bewegt werden.

12. Vorrichtung (1) gemäß dem vorherigen Anspruch,
wobei jeder der Hebelarme (4a, 4b) einen ersten Endabschnitt (6a, 6b) und einen zweiten Endabschnitt (7a, 7b) aufweist,
wobei die zweiten Endabschnitte (7a, 7b) jeweils eine Dünnstelle (11, 14) aufweisen,
wobei die ersten Endabschnitte (6a, 6b) jeweils über eine Dünnstelle (10, 15) mit der Teilstruktur (9) verbunden sind, und
wobei die Dünnstellen (10, 11, 14, 15) in einer Ebene liegen.

13. Vorrichtung (1) gemäß einem der vorherigen Ansprüche,
wobei die mechanische Struktur (3) mehrteilig ist und
wobei die Vorrichtung (1) eine Haltevorrichtung aufweist, die dazu ausgestaltet ist, auf die mechanische Struktur (3) von außen eine Kraft auszuüben, durch die die mechanische Struktur (3) zusammengehalten wird.

14. Vorrichtung (1) gemäß einem der vorherigen Ansprüche,
wobei der piezoelektrischen Aktuator (2) einen Vielschichtaufbau aufweist, bei dem in einer Stapelrichtung Innenelektroden und piezoelektrische Schichten abwechselnd übereinander angeordnet sind, wobei die erste Richtung (x) parallel zu der Stapelrichtung ist.

15. Elektronisches Gerät, aufweisend eine Vorrichtung (1) zur Erzeugung einer haptischen Rückmeldung gemäß einem der vorherigen Ansprüche,
ein erstes Gehäuseelement und ein zweites Gehäuseelement, wobei das erste Gehäuseelement und das zweite Gehäuseelement derart an der mechanischen Struktur (3) befestigt sind, dass bei einer Änderung der Ausdehnung des piezoelektrischen Aktuators (2) in die erste Richtung (x) die Gehäuseelemente relativ zueinander bewegt werden.

## Claims

1. Apparatus (1) for producing haptic feedback, having a piezoelectric actuator (2) and a mechanical structure (3),
wherein the piezoelectric actuator (2) is designed to modify its extension in a first direction (x), and wherein the mechanical structure (3) is designed to deform as a result of a change in the extension of the piezoelectric actuator (2) in such a way that an area (5a, 5b) of the mechanical structure (3) is moved in relation to the piezoelectric actuator (2) in a second direction (y) which is perpendicular to the first direction (x),
**characterized in that**
the mechanical structure (3) has a substructure (9) which is designed not to move in the second direction in relation to the piezoelectric actuator (2) as a result of a change in the extension of the piezoelectric actuator (2),
wherein the haptic feedback is produced by a movement of the area (5a, 5b) in relation to the substructure (9), wherein the substructure (9) extends in the first direction (x) in the form of a bar, and wherein the substructure (9) is arranged parallel to the piezoelectric actuator (2).

2. Apparatus (1) according to the preceding claim,
wherein the mechanical structure (3) is designed so that, as a result of a change in the extension of the piezoelectric actuator (2), the area (5a, 5b) of the mechanical structure (3) is moved in the second direction (y) by a distance which is at least ten times greater than the change in the extension of the piezoelectric actuator (2) in the first direction (x).

3. Apparatus (1) according to the preceding claim,
wherein the substructure (9) runs at a distance of less than 1 mm parallel to the piezoelectric actuator (2).

4. Apparatus (1) according to one of the preceding claims,
wherein the mechanical structure (3) has a first lever arm (4a) which has the area (5a), and
wherein a first end of the piezoelectric actuator (2) is fixed to the first lever arm (4a).

5. Apparatus (1) according to Claim 4,
wherein the first lever arm (4a) is movably connected to the substructure (9).

6. Apparatus (1) according to the preceding claim,
wherein the first lever arm (4a) and the substructure (9) are one piece and are flexibly interconnected via a thin area (10),
or
wherein the first lever arm (4a) and the substructure (9) are a plurality of pieces and are movably interconnected via a joint.

7. Apparatus (1) according to one of Claims 4 to 6,
wherein the first lever arm (4a) has a first end section (6a), a second end section (7a) and a mid-section (8a), wherein the end sections (6a, 7a) are parallel to one another, and
wherein the mid-section (8a) interconnects the two end sections (6a, 7a) and is perpendicular to the two end sections (6a, 7a), and
wherein the area (5a) which is designed to be moved in the second direction (y) in the event of a deformation of the mechanical structure (3) is arranged in the mid-section (8a).

8. Apparatus (1) according to the preceding claim,
wherein the first lever arm (4a) is designed so that the two end sections (6a, 7a) are either pushed apart or drawn together as a result of a change in the extension of the piezoelectric actuator (2), whereby the mid-section (8a) becomes arched.

9. Apparatus (1) according to one of Claims 7 or 8, wherein the first end section (6a) is movably attached to the substructure (9), and
wherein one end of the piezoelectric actuator (2) is fixed to the first end section (6a).

10. Apparatus (1) according to one of Claims 7 to 9,
wherein the second end section (7a) has a thin area (11) which subdivides the second end section (7a) into a first subsection (12a) and a second subsection (12b) which are flexible in relation to one another,
wherein the first subsection (12a) adjoins the mid-section (8a), and
wherein the second subsection (12b) is designed to be fixed to an attachment apparatus.

11. Apparatus (1) according to one of Claims 4 to 10,
wherein the mechanical structure (3) has a second lever arm (4b) which has an area (5b) which is designed to move in the second direction (y) in the event of a deformation of the mechanical structure (3) as a result of a change in the extension of the piezoelectric actuator (2),
wherein a second end of the piezoelectric actuator (2) is fixed to the second lever arm (4b), and
wherein the lever arms (4a, 4b) are designed in such a way that the area (5a) of the first lever arm (4a) and the area (5b) of the second lever arm (4b) are always moved in the same direction.

12. Apparatus (1) according to the preceding claim,
wherein each of the lever arms (4a, 4b) has a first end section (6a, 6b) and a second end section (7a, 7b), wherein the second end sections (7a, 7b) in each case have a thin area (11, 14),
wherein the first end sections (6a, 6b) are connected in each case via a thin area (10, 15) to the substructure (9), and
wherein the thin areas (10, 11, 14, 15) lie in one plane.

13. Apparatus (1) according to one of the preceding claims,
wherein the mechanical structure (3) has a plurality of parts, and
wherein the apparatus (1) has a holding apparatus which is designed to exert a force from outside on the mechanical structure (3), by means of which the mechanical structure (3) is held together.

14. Apparatus (1) according to one of the preceding claims,
wherein the piezoelectric actuator (2) has a multi-layer structure in which internal electrodes and piezoelectric layers are arranged alternately above one another in a stacking direction,
wherein the first direction (x) is parallel to the stacking direction.

15. Electronic device, having an apparatus (1) for producing haptic feedback according to one of the preceding claims, a first housing element and a second housing element, wherein the first housing element and the second housing element are attached to the mechanical structure (3) in such a way that the housing elements are moved in relation to one another in the event of a change in the extension of the piezoelectric actuator (2) in the first direction (x).

## Revendications

1. Dispositif (1) permettant de générer un retour haptique,
présentant un actionneur piézoélectrique (2) et une structure mécanique (3),
dans lequel l'actionneur piézoélectrique (2) est configuré pour modifier son étendue dans une première direction (x), et
dans lequel la structure mécanique (3) est configurée pour se déformer suite à une modification de l'étendue de l'actionneur piézoélectrique (2) de telle sorte qu'une zone (5a, 5b) de la structure mécanique (3) est déplacée par rapport à l'actionneur piézoélectrique (2) dans une deuxième direction (y) qui est perpendiculaire à la première direction (x),
**caractérisé en ce que**
- la structure mécanique (3) présente une structure partielle (9) qui, suite à une modification de l'étendue de l'actionneur piézoélectrique (2), est configurée pour ne pas se déplacer par rapport à l'actionneur piézoélectrique (2) dans la deuxième direction,
dans lequel le retour haptique est généré par un mouvement relatif de la zone (5a, 5b) par rapport à la structure partielle (9),
dans lequel la structure partielle (9) s'étend dans la première direction (x) en forme de barre, et dans lequel la structure partielle (9) est disposée en parallèle à l'actionneur piézoélectrique (2).

2. Dispositif (1) selon la revendication précédente, dans lequel la structure mécanique (3) est configurée de telle sorte que suite à une modification de l'étendue de l'actionneur piézoélectrique (2), la zone (5a, 5b) de la structure mécanique (3) est déplacée sur un trajet dans la deuxième direction (y) qui est au moins dix fois plus grand que la modification de l'étendue de l'actionneur piézoélectrique (2) dans la première direction (x).

3. Dispositif (1) selon la revendication précédente, dans lequel la structure partielle (9) s'étend à une distance de moins de 1 mm en parallèle à l'actionneur piézoélectrique (2).

4. Dispositif (1) selon l'une quelconque des revendications précédentes, dans lequel la structure mécanique (3) présente un premier bras de levier (4a) qui présente la zone (5a), et dans lequel une première extrémité de l'actionneur piézoélectrique (2) est fixée au premier bras de levier (4a).

5. Dispositif (1) selon la revendication 4, dans lequel le premier bras de levier (4a) est relié de manière mobile à la structure partielle (9).

6. Dispositif (1) selon la revendication précédente,
dans lequel le premier bras de levier (4a) et la structure partielle (9) sont réalisés d'une seule pièce et sont reliés ensemble de manière flexible par l'intermédiaire d'une partie amincie (10),
ou
dans lequel le premier bras de levier (4a) et la structure partielle (9) sont réalisés en plusieurs pièces et sont reliées ensemble de manière mobile par l'intermédiaire d'une articulation.

7. Dispositif (1) selon l'une quelconque des revendications 4 à 6, dans lequel le premier bras de levier (4a) présente une première section d'extrémité (6a), une deuxième section d'extrémité (7a) et une section centrale (8a), dans lequel les sections d'extrémité (6a, 7a) sont parallèles l'une à l'autre, et dans lequel la section centrale (8a) relie les deux sections d'extrémité (6a, 7a) l'une à l'autre et est perpendiculaire aux deux sections d'extrémité (6a, 7a), et dans lequel la zone (5a) qui est configurée pour être déplacée dans la deuxième direction (y), en cas de déformation de la structure mécanique (3), est disposée dans la section centrale (8a).

8. Dispositif (1) selon la revendication précédente, dans lequel le premier bras de levier (4a) est configuré de telle sorte que suite à une modification de l'étendue de l'actionneur piézoélectrique (2), les deux sections d'extrémité (6a, 7a) sont soit écartées soit rapprochées, de sorte que la section centrale (8a) se bombe.

9. Dispositif (1) selon l'une quelconque des revendications 7 ou 8, dans lequel la première section d'extrémité (6a) est fixée de manière mobile à la structure partielle (9), et dans lequel une extrémité de l'actionneur piézoélectrique (2) est fixée à la première section d'extrémité (6a).

10. Dispositif (1) selon l'une quelconque des revendications 7 à 9,
dans lequel la deuxième section d'extrémité (7a) présente une partie amincie (11) qui divise la deuxième section d'extrémité (7a) en une première section partielle (12a) et une deuxième section partielle (12b) qui sont flexibles l'une par rapport à l'autre,
dans lequel la première section partielle (12a) est consécutive à la section centrale (8a), et
dans lequel la deuxième section partielle (12b) est configurée pour être fixée à un dispositif de fixation.

11. Dispositif (1) selon l'une quelconque des revendications 4 à 10,
dans lequel la structure mécanique (3) présente un deuxième bras de levier (4b) qui présente une zone (5b) qui est configurée pour se déplacer dans la deuxième direction (y) en cas de déformation de la structure mécanique (3) suite à une modification de l'étendue de l'actionneur piézoélectrique (2),
dans lequel une deuxième extrémité de l'actionneur piézoélectrique (2) est fixée au deuxième bras de levier (4b), et
dans lequel les bras de levier (4a, 4b) sont configurés de telle sorte que la zone (5a) du premier bras de levier (4a) et la zone (5b) du deuxième bras de levier (4b) sont toujours déplacées dans la même direction.

12. Dispositif (1) selon la revendication précédente,
dans lequel chacun des bras de levier (4a, 4b) présente une première section d'extrémité (6a, 6b) et une deuxième section d'extrémité (7a, 7b),
dans lequel les deuxièmes sections d'extrémité (7a, 7b) présentent respectivement une partie amincie (11, 14),
dans lequel les premières sections d'extrémité (6a, 6b) sont respectivement reliées à la structure partielle (9) par l'intermédiaire d'une partie amincie (10, 15), et
dans lequel les parties amincies (10, 11, 14, 15) se trouvent dans un seul plan.

13. Dispositif (1) selon l'une quelconque des revendications précédentes,
dans lequel la structure mécanique (3) est réalisée en plusieurs pièces, et
dans lequel le dispositif (1) présente un dispositif de maintien qui est configuré pour exercer de l'extérieur une force sur la structure mécanique (3) qui assure le maintien de la structure mécanique (3).

14. Dispositif (1) selon l'une quelconque des revendications précédentes, dans lequel l'actionneur piézoélectrique (2) présente une construction multicouche dans laquelle, dans une direction d'empilement, des électrodes intérieures et des couches piézoélectriques sont disposées en alternance les unes au-dessus des autres, la première direction (x) étant parallèle à la direction d'empilement.

15. Appareil électronique, présentant un dispositif (1) pour générer un retour haptique selon l'une quelconque des revendications précédentes,
un premier élément de boîtier et un deuxième élément de boîtier, dans lequel le premier élément de boîtier et le deuxième élément de boîtier sont fixés à la structure mécanique (3) de telle sorte qu'en cas de modification de l'étendue de l'actionneur piézoélectrique (2) dans la première direction (x), les éléments de boîtier sont déplacés l'un par rapport à l'autre.
